Europäisches Patentamt

European Patent Office

Office européen des brevets

(11) Veröffentlichungsnummer: **0 329 967**

**A1**

## (12) EUROPÄISCHE PATENTANMELDUNG

(21) Anmeldenummer: **89101315.3**

(22) Anmeldetag: **26.01.89**

(51) Int. Cl.⁴: **H03F 3/217**

(30) Priorität: **24.02.88 DE 3805754**

(43) Veröffentlichungstag der Anmeldung:
**30.08.89 Patentblatt 89/35**

(84) Benannte Vertragsstaaten:
**CH DE FR GB LI**

(71) Anmelder: **AEG Olympia Aktiengesellschaft
Postfach 960
D-2940 Wilhelmshaven(DE)**

(72) Erfinder: **Lodahl, Manfred, Dipl.-Ing.
Spindelmühlerweg 6
D-1000 Berlin 45(DE)**

(74) Vertreter: **Schulze, Harald Rudolf, Dipl.-Ing.
c/o AEG Aktiengesellschaft Patente und
Lizenzen Theodor-Stern-Kai 1
D-6000 Frankfurt 70(DE)**

(54) **Digitaler Schaltverstärker.**

(57) Ein digitaler Schaltverstärker mit mehreren in Reihe geschalteten schaltbaren Teilspannungsquellen ($U_1$-$U_N$) und jeweils parallel geschalteten Freilaufdioden ($D_1$-$D_N$) enthält einen Modulselektor (MS), der nach Maßgabe der von einer Steuereinheit (ST) vorgegebenen Zahl der zu schaltenden Teilspannungsquellen und weiterer Informationen von einer Recheneinheit (RE) über die jeweiligen Belastungen der einzelnen Teilspannungsquellen ($U_1$-$U_N$) die zu schaltenden Teilspannungsquellen auswählt.

FIG.1

EP 0 329 967 A1

EP 0 329 967 A1

## Digitaler Schaltverstärker

Die Erfindung betrifft einen Schaltverstärker zur digitalen Leistungsverstärkung eines Eingangssignals nach dem Oberbegriff des Patentanspruchs 1. Schaltverstärker dieser Art werden insbesondere zur Erzeugung von in ihrer Amplitude veränderlichen Hochspannungen eingesetzt, beispielsweise in einer Hochspannungs-Gleichstromversorgung für Teilchenbeschleunigeranlagen oder in einem Modulationsverstärker zur Erzeugung einer amplitudenmodulierten Anodenspannung eines Rundfunksenders hoher Leistung. Ein solcher Schaltverstärker ist beispielsweise aus der EP-0 124 765 A1 bekannt.

Der bekannte Schaltverstärker besteht aus einer Reihenschal tung von mehreren gleichartigen und unabhängig voneinander schaltbaren Teilspannungsquellen mit jeweils parallel geschalteten Freilaufdioden. Eine Steuereinheit ermittelt entsprechend dem momentanen Pegel des zu verstärkenden Eingangssignals und vorgegebener Betriebsparameter, welche und wieviel der Teilspannungsquellen zu schalten sind, wobei die Ein- und Ausschaltungen überlicherweise getaktet, d.h. in bestimmten zeitlichen Abständen erfolgen.

Schaltverstärker dieser Art verstärken beispielsweise ein analoges Eingangssignal in quantisierter Form durch entsprechende Zu- oder Abschaltung einzelner in Serie geschalteter Teilspannungsquellen, indem die Steuereinheit den zulässigen Eingangssignalbereich in eine der Anzahl der Teilspannungsquellen entsprechende Anzahl von Spannungsstufen unterteilt sowie durch Vergleich des momentanen Pegels Eingangssignals mit diesen Spannungsstufen die Zahl der Teilspannungsquellen ermittelt, die im Prinzip einzuschalten wären, um den momentanen Pegel des Eingangssignals mit dem vorgegebenen Verstärkungsfaktor zu verstärken und durch Vergleich dieser Zahl mit der Zahl der bereits eingeschalteten Teilspannungsquellen die Zahl der tatsächlich ein- oder auszuschaltenden Teilspannungsquellen bestimmt. Die resultierende Ausgangsspannung des Schaltverstärkers, die durch die Aufsummation der Teilspannungen der jeweils eingeschalteten Teilspannungsquellen gebildet wird und somit das verstärkte Eingangssignal darstellt, weist dabei systembedingt einen Quantisierungsfehler ("Quantisierungsrauschen") in Höhe des Ausgangsspannungswertes einer Teilspannungsquelle auf. Die Schalt- oder Taktfrequenz liegt dabei bedeutend höher (min destens um den Faktor 2) als die höchste Frequenz des Eingangssignals. Zur Aussiebung der Schaltfrequenz und deren Harmonische wird das verstärkte Signal üblicherweise über ein Tiefpaßfilter einer Last zugeführt. Im Falle des Modulationsverstärkers eines Rundfunksenders ist die Last die Hochfrequenzendstufe des Senders.

In der Anwendung des Schaltverstärkers als Modulationsverstärker eines Rundfunksenders großer Leistung müssen für eine optimale Auslegung der Stromversorgungseinrichtungen für die Teilspannungsquellen Vorkehrungen für eine möglichst gleiche Belastung der einzelnen Teilspannungsquellen getroffen werden.

Aus den hohen Qualitätsforderungen an einen Rundfunksender, wie z.B. kleiner Klirrfaktor, hohe Dämpfung der Geräuschspannung und Einhaltung der Empfehlungen für die Randaussendungen gemäß CCIR 328-5 :"Out-of-band spectrum" ergibt sich die Notwendigkeit, daß die einzelnen Teilspannungsquellen keine systembedingten unterschiedlichen Spannungswerte aufweisen dürfen. Unterschiedliche Belastungen der Teilspannungsquellen ergeben aufgrund vorhandener Innenwiderstände unterschiedliche Spannungswerte. Systembedingte Unterschiede der Spannungswerte sonst gleicher Teilspannungsquellen ergeben bei wahlweiser Ein- und Ausschaltung der Teilspannungsquellen einen Beitrag zum Quantisierungsrauschen. Durch ein zu hohes Quantisierungsrauschen werden insbesondere die Grenzwerte für die zulässigen Randaussendungen eines Rundfunksenders überschritten.

Um eine gleichmäßige Verteilung der Belastung über sämtliche Teilspannungsquellen zu erzielen, wurde in der EP-0 124 765 A1 eine Steuerung für einen digitalen Leistungsverstärker vorgeschlagen, bei der jede Teilspannungsquelle mit einer Zeitmeßeinrichtung zur Messung der Zeit zwischen zwei aufeinanderfolgenden Schaltvorgängen und einem Speicher zur Speicherung des jeweiligen Schaltzustandes verbunden ist und die Zeitmeßeinrichtungen und Speicher mit einer Vergleichslogik verbunden sind. Die Vergleichslogik vergleicht die Werte der Zeitmeßeinrichtungen und wählt für den nächsten Schaltvorgang diejenige Teilspannungsquelle aus, die nach ihrem Schaltzustand geeignet ist und ihren Schaltzustand die längste Zeit nicht geändert hat.

Eine Steuerung, die nur auf einer Zeitmessung der Schaltzustände der Teilspannungsquellen beruht, ist wenig geeignet für eine gewünschte gleichmäßige Verteilung der Belastung über sämtliche Teilspannungsquellen eines digitalen Leistungsverstärkers. Eine zeitliche Gleichbehandlung aller Teilspannungsquellen bedeutet keine gleichmäßige Belastungsverteilung. Wenn z.B. bei Vollaussteuerung des Verstärkers mit einem Einzelton mit Spannungsanstieg von Null ausgehend die erste Teilspannungsquelle eingeschaltet wird und nach dem in der genannten Druckschrift angegebenen Zeitmeßverfahren bei Überschreiten des maximalen Spannungswertes wieder ausgeschaltet wird, in ihrer Leistung verglichen wird mit der Leistung

2

einer Teilspannungsquelle, die im Fall des Spannungsanstiegs bei halber Spannung eingeschaltet und bei Spannungsabfall entsprechend wieder bei halber Spannung ausgeschaltet wird, so sind beide Spannungsquellen gleich lange in Betrieb, letztere jedoch hat eine um 64 % höhere Leistung zu erbringen. Die Forderung an eine gleichmäßige Belastungsverteilung über die einzelnen Teilspannungsquellen ist nicht erfüllt; unterschiedliche Spannungswerte der einzelnen Teilspannungsquellen verursachen jedoch einen nicht vernachlässigbaren Beitrag zum unerwünschten Quantisierungsrauschen.

Der Erfindung liegt daher die Aufgabe zugrunde, einen gattungsgemäßen Schaltverstärker anzugeben, bei dem die einzelnen Teilspannungsquellen möglichst gleichmäßig belastet sind.

Diese Aufgabe wird gelöst durch die im kennzeichnenden Teil des Patentanspruchs 1 angegebenen Merkmale. Zweckmäßige Ausgestaltungen und/oder Weiterbildungen sowie bevorzugte Anwendungen sind den übrigen Ansprüchen entnehmbar.

Die Erfindung basiert auf der Erkenntnis, daß eine gleichmäßige Belastung aller Teilspannungsquellen dann erreicht ist, wenn die Leistung aller Teilspannungsquellen gleich ist.

Die Leistung einer Teilspannungsquelle ist

$$P = U \bullet \frac{1}{T} \int_0^T i(t)dt \qquad (1)$$

Dabei ist U die für alle Teilspannungsquellen gleiche Spannung und $\int_0^T i(t)dt$ die über einen Erfassungszeitraum T von der Teilspannungsquelle gelieferte Ladungsmenge Q. Der Erfassungszeitraum T ist zweckmäßig größer zu wählen als die längste Periodendauer der Frequenzen des zu verstärkenden Eingangssignals.

Der Erfassungszeitraum T ist ein Zeitfenster, das sich bis zum augenblicklichen Zeitpunkt des Betriebsgeschehens erstreckt.

Ein digitaler Verstärker ist, wie bereits eingangs erwähnt, meist ein getakteter Verstärker. In diesem Fall fällt innerhalb eines Erfassungszeitraumes T eine bestimmte Anzahl von Takten. Die Ermittlung des Ausdrucks $\frac{1}{T} \int_0^T i(t)dt$ kann gemäß der nachfolgenden rechnerischen Ausführungen über eine Aufsummierung der zu jedem Takt zugehörigen Stromwerte erfolgen:

Sind $t_1$, $t_2$; ...$t_n$ Taktzeiten, $t_0$ die Taktdauer $t_2$-$t_1$; $t_3$-$t_2$; ...$t_{n-1}$-$t_n$ und n die Anzahl der Takte im Erfassungszeitraum T, so ergibt sich mit $n \bullet t_0 = T$ für die jeweilige Teilspannungsquelle approximiert:

$$\frac{1}{T} \int_0^T i(t)dt = \frac{1}{T} \int_0^{t_1} i_1(t)dt +$$

$$\int_{t_1}^{t_2} i_2(t)dt + \ldots + \int_{t_{n-1}}^{t_n} i_n(t)dt$$

$$= \frac{1}{n \cdot t_0} (i_1 \cdot t_0 + i_2 \cdot t_0 + \ldots i_n \cdot t_0)$$

$$= \frac{1}{n} (i_1 + i_2 - \ldots + i_n) \qquad (2)$$

Dabei sind $i_1$, $i_2$ ...$i_n$ die von einer Stromerfassungseinrichtung SE einer Recheneinheit RE taktweise gemeldeten Stromwerte des digitalen Schaltverstärkers.

Der Wert $\frac{1}{T} \int_0^T i(t)dt$ wird laufend, vorzugsweise taktweise, für jede Teilspannungsquelle neu ermittelt und das Ergebnis in einem Speicher abgelegt. Hierzu sind, entsprechend der rechnerischen Ausführungen, lediglich die taktweise festgestellten Stromwerte des digitalen Schaltverstärkers über den Erfassungszeitraum T zu addieren. Da es sich bei dem Erfassungszeitraum T um ein Zeitfenster handelt, muß bei jedem neuen Takt der innerhalb des Erfassungszeitraums T gespeicherte erste Stromwert getilgt und dafür der neue Stromwert bei der Addition der einzelnen Stromwerte berücksichtigt werden.

Ist aufgrund einer Änderung der zu verstärkenden Signalspannung eine Teilspannungsquelle einzu-

3

schalten, so wird diejenige eingeschaltet, deren $\frac{1}{T} \int_0^T$ i(t)dt-Wert am größten ist.

Wenn keine Änderung der zu verstärkenden Signalspannung erfolgt, wird nach einer festzulegenden Taktzahl eine Ein-und Ausschaltung jeweils einer Teilspannungsquelle herbeigeführt, um auch bei statischer Aussteuerung eine gleichmäßige Belastung aller Teilspannungsquellen zu gewährleisten.

Eine Modifikation des angegebenen Verfahrens besteht darin, die Schaltung der Teilspannungsquellen zusätzlich in Abhängigkeit einer vorgegebenen Toleranz für den Leistungsunterschied der einzelnen Teilspannungsquellen erfolgen zu lassen. In diesem Fall erhöht sich die Zahl der Schaltungen über das Maß der von der Steuereinheit ST vorgegebenen Zahl hinaus. Zwar steigen in diesem Fall die durch die Schaltvorgänge gegebenen Schaltverluste, die Belastungsverteilung auf die einzelnen Teilspannungsquellen kann aber dafür beliebig klein gehalten werden.

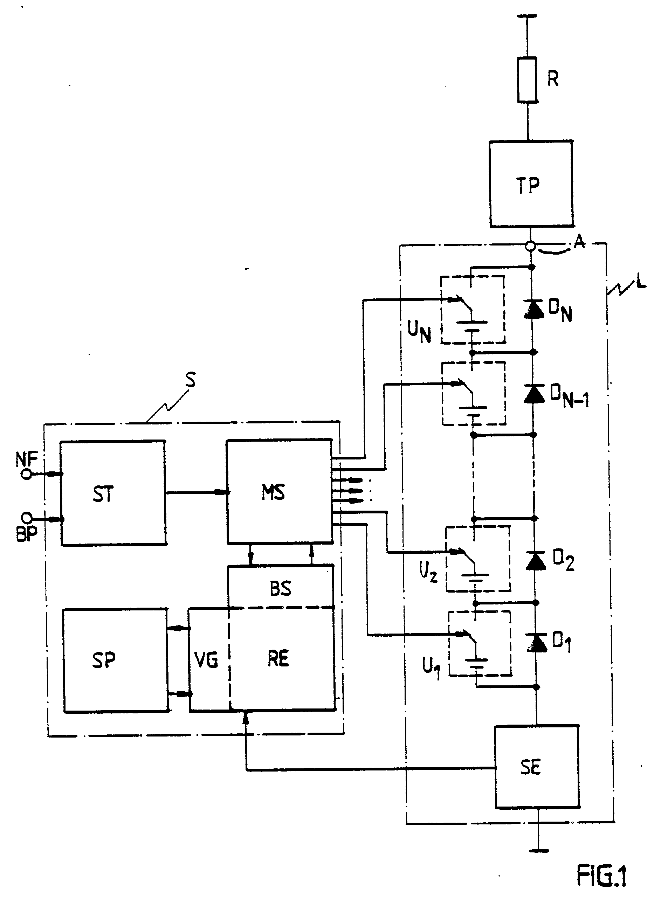

Die Erfindung wird im folgenden anhand eines vorteilhaften Ausführungsbeispiels unter Bezugnahme auf FIG. 1 näher erläutert.

Der erfindungsgemäße Schaltverstärker in FIG. 1 besteht aus einem Leistungsteil L und einem Steuerungsteil S. Der Leistungsteil besteht aus einer Reihenschaltung von schaltbaren Teilspannungsquellen $U_1$ bis $U_N$, denen jeweils eine Freilaufdiode $D_1$ bis $D_N$ parallel geschaltet ist. Der Ausgang A ist über ein Tiefpaßfilter TP an eine beispielhaft als rein ohmsch angenommene Last R angeschlossen, z.B. eine amplitudenmodulierbare Hochfrequenzendstufe eines Rundfunksenders großer Leistung. Am Fußpunkt der Reihenschaltung der schaltbaren Teilspannungsquellen und parallel geschalteten Freilaufdioden ist eine Stromerfassungseinrichtung SE angeschlossen, deren zweiter Anschluß an Masse liegt.

Der Steuerungsteil besteht aus einer Steuereinheit ST, einer Recheneinheit RE, einem Modulselektor MS sowie einem Speicher SP, einem Betriebsspeicher BS und einem Vergleicher VG.

Der Steuereinheit ST wird das zu verstärkende Eingangssignal NF zugeführt, das im Falle eines Modulationsverstärkers für einen Rundfunksender das niederfrequente Modulationssignal ist. Außerdem werden der Steuereinheit ST noch Betriebsparameter BP zugeführt, die z.B. unterschiedliche Leistungen oder Betriebsarten des Senders berücksichtigen.

In der Steuereinheit wird das Eingangssignal, z.B. das niederfrequente Eingangssignal NF des Senders, digitalisiert. Unter Berücksichtigung der Betriebsparameter BP werden dem Modulselektor MS von der Steuereinheit ST taktweise Informationen über die Zahl der ein- oder auszuschaltenden Teilspannungsquellen für den Verstärkungsvorgang übermittelt. Der Modulselektor MS übermittelt seinerseits der Rechenheit RE taktweise den Schaltzustand aller Teilspannungsquellen. Die Recheneinheit RE liefert ihrerseits dem Modulselektor MS taktweise den Belastungszustand der einzelnen Teilspannungsquellen $U_1$ bis $U_N$, indem die über einen vorgegebenen Erfassungszeitraum T als Zeitfenster ermittelten $\frac{1}{T} \int_0^T$ i(t)dt-Werte für den Modulselektor MS errechnet werden.

Aufgrund der Informationen von der Recheneinheit RE über den Belastungszustand der einzelnen Teilspannungsquellen $U_1$ bis $U_N$ und der Informationen von der Steuereinheit ST über die Anzahl der aus- oder einzuschaltenden Teilspannungsquellen wählt der Modulselektor MS die zu schaltenden Teilspannungsquellen aus und veranlaßt die Schaltung.

Die Stromwerte des digitalen Verstärkers zur Errechnung der $\frac{1}{T} \int_0^T$ i(t)dt-Werte erhält die Recheneinheit RE ebenfalls taktweise von einer Stromerfassungseinrichtung SE im Leistungsteil L des erfindungsgemäßen Schaltverstärkers. Der augenblickliche Stromwert wird vorzugsweise jeweils in der Mitte der Taktperiode für die Schaltspannung ermittelt zur Vermeidung von Fehlmessungen durch Transienten bei den Schaltvorgängen.

Zur Ermittlung der $\frac{1}{T} \int_0^T$ i(t)dt-Werte für die einzelnen Teilspannungsquellen $U_1$ bis $U_N$ werden die zu den Takten gehörigen Stromwerte in dem Speicher SP für den Erfassungszeitraum T gespeichert. Ebenso werden in dem Speicher SP sämtliche $\frac{1}{T} \int_0^T$ i(t)dt-Werte abgelegt.

Der Vegleicher VG im Rechenwerk RE erarbeitet Prioritätenlisten für das Ein- und Ausschalten von Teilspannungsquellen und legt diese Informationen in dem dem Rechenwerk RE zugehörigen Betriebsspeicher BS ab, zu dem der Modulselektor MS Zugriff hat.

Es versteht sich, daß die Erfindung mit fachmännischem Wissen und Können aus- und weitergebildet sowie an die unterschiedlichen Anwendungen angepaßt werden kann, ohne daß dies hier an dieser Stelle näher erläutert werden muß.

So ist es z.B. denkbar, anstelle von analogen Eingangssignalen quantisierte Eingangssignale oder bereits digitalisierte Analogsignale zu werdenden.

Weiterhin ist es möglich, den Quantisierungsfehler dadurch zu verringern, daß in den vorhandenen Teilspannungsquellen (Grobstufen) mit den Ausgangsspannungen $U_1 = U_2 = \ldots = U_N = U$ weitere Teilspannungsquellen (Feinstufen) mit z.B. binär gewichteten Ausgangsspannungen U/2; U/4; U/8 ... in Reihe geschaltet werden.

Außerdem ist es möglich, alternativ oder in Ergänzung zu den Feinstufen eine weitere Teilspannungsquelle mit der Ausgangsspannung U in Reihe zu schalten, die entsprechend dem verbleibenden Quantisierungsfehler pulsdauermoduliert ein-und ausgeschaltet wird (PDM-Feinstufe).

Ferner ist es möglich, gemäß einer weiteren, bislang noch nicht veröffentlichten Anmeldung P 38 03 583.9 eine Teilspannungsquelle mit einer Ausgangsspannung von z.B. 0,2 U (Shiftstufe) zusätzlich mit den anderen Teilspannungsquellen in Reihe zu schalten, die normalerweise inaktiv ist und die nur dann aktiviert wird, wenn es zu häufigen Ein- und Ausschaltungen der Grobstufen kommt, beispielsweise infolge von Schwankungen in der die Stufen speisenden Netzspannung oder infolge von geringen Amplitudenschwankungen des Eingangssignals um einen mittleren Amplitudenwert, der gerade mit einer der Spannungsstufen des Eingangssignalbereichs übereinstimmt.

Schließlich ist es denkbar, wesentliche Teile der Steuerung mit einem Mikroprozessor oder Mikro- bzw. Minicomputer zu realisieren.

## Ansprüche

1. Schaltverstärker zur digitalen Leistungsverstärkung eines Eingangssignals, bestehend aus einer Reihenschaltung von mehreren, unabhängig voneinander schaltbaren Teilspannungsquellen mit jeweils parallel geschalteten Freilaufdioden und einer Steuereinheit, welche die Zahl der zu schaltenden Teilspannungsquellen entsprechend dem momentanen Pegel des zu verstärkenden Eingangssignals und vorgegebener Betriebsparameter des Schaltverstärkers ermittelt, dadurch gekennzeichnet, daß ein Modulselektor (MS) nach Maßgabe der von der Steuereinheit (ST) vorgegebenen Zahl der zu schaltenden Teilspannungsquellen und weiterer Informationen von einer Recheneinheit (RE) über die jeweilige Belastung der einzelnen Teilspannungsquellen ($U_1$ bis $U_N$) die zu schaltenden Teilspannungsquellen auswählt.

2. Schaltverstärker nach Anspruch 1, dadurch gekennzeichnet, daß eine Stromerfassungseinrichtung (SE) den in der Reihenschaltung der schaltbaren Teilspannungsquellen ($U_1$ bis $U_N$) mit parallel geschalteten Freilaufdioden ($D_1$ bis $D_N$) fließenden Strom i(t) mißt und der Recheneinheit (RE) meldet und daß die Recheneinheit (RE) als weitere Information die Schaltzustände der einzelnen Teilspannungsquellen ($U_1$ bis $U_N$) von dem Modulselektor (MS) erhält.

3. Schaltverstärker nach Anspruch 2, dadurch gekennzeichnet, daß die Betriebsdauer des Schaltverstärkers in Erfassungszeiträume T unterteilt ist und daß die Recheneinheit (RE) für jede der Teilspannungsquellen ($U_1$ bis $U_N$) und über jeden der Erfassungszeiträume T das Integral $\frac{1}{T} \int_0^T i(t)dt$ errechnet und diese Werte dem Modulselektor (MS) für das Auswählen der zu schaltenden Teilspannungsquellen unter Zuhilfenahme eines Vergleichers (VG) und von Speichereinheiten (SP, BS) zur Verfügung stellt.

4. Schaltverstärker nach einem der Ansprüche 2 bis 3, dadurch gekennzeichnet, daß die Ein- und Ausschaltungen der Teilspannungsquellen getaktet erfolgen und daß mit jedem Takt bei Vorliegen einer Schaltinformation von der Steuereinheit (ST) gemäß der von der Recheneinheit (RE) errechneteten Werte durch den Modulselektor (MS) die Ein- bzw. Ausschaltungen der Teilspannungsquellen erfolgen und bei Nichtvorliegen einer Schaltinformation von der Steuereinheit (ST) eine Schaltung von mindestens zwei Teilspannungsquellen jeweils nach Ablauf einer vorgegebenen Anzahl von Takten durch den Modulselektor (MS) erfolgt.

5. Schaltverstärker nach einem der Ansprüche 2 bis 4, dadurch gekennzeichnet, daß der Modulselektor (MS) bei Überschreiten einer vorgegebenen Toleranz für die Differenz der sich aus dem gemessenen Strom i(t) ergebenden gelieferten Ladungsmengen von den einzelnen Teilspannungsquellen in einem der Erfassungszeiträume T Schaltungsvorgänge auslöst, indem er bei Lieferung einer vergleichweise zu großen Ladungsmenge durch eine Teilspannungsquelle diese abschaltet und dafür diejenige Teilspannungsquelle einschaltet, die die geringste Ladungsmenge in deisem Erfassungszeitraum T geliefert hat.

6. Schaltverstärker nach einem der Ansprüche 3 bis 5, dadurch gekennzeichnet, daß die Erfassungszeiträume T gleich groß sind und jeweils größer sind als die längste Periodendauer der Frequenzen des zu verstärkenden Eingangssignals.

7. Schaltverstärker nach Anspruch 6, dadurch gekennzeichnet, daß die Erfassungszeiträume T jeweils ein ganzzahliges Vielfaches der Zeitdauer $t_0$ zwischen zwei aufeinanderfolgenden Takten sind.

8. Schaltverstärker nach einem der Ansprüche 1 bis 7, dadurch gekennzeichnet, daß das Eingangssignal ein analoges oder ein quantisiertes oder ein bereits digitalisiertes analoges und vorzugsweise niederfrequentes Signal ist.

9. Schaltverstärker nach einem der Ansprüche 1 bis 8, dadurch gekennzeichnet, daß der Reihenschaltung von schaltbaren Teilspannungsquellen ($U_1$ bis $U_N$) mit parallel geschal teten Freilaufdioden ($D_1$ bis $D_N$) ausgangsseitig ein Tiefpaßfilter nachgeschaltet ist.

10. Schaltverstärker nach einem der Ansprüche 1 bis 9, gekennzeichnet durch die Anwendung in einer Hochspannungs-Gleichstromversorgung oder in einem Modulationsverstärker zur Erzeugung einer amplitudenmodulierten Anodenspannung eines Rundfunksenders hoher Leistung.

11. Schaltverstärker nach einem der Ansprüche 1 bis 10, dadurch gekennzeichnet, daß wesentliche Teile des Steuerungsteils (S) mit einem Mikroprozessor oder Mikro- bzw. Minicomputer realisiert sind.

FIG.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | EP-A-0 124 765 (BBC AG) * Figuren 1-4,5c; Seite 11, Zeile 12 - Seite 15, Zeile 2 * --- | 1,8,10 | H 03 F 3/217 |
| A | EP-A-0 218 152 (LICENTIA PATENT-VERWALTUNG) * Figuren 1,7,12; Spalte 15, Zeile 31 - Spalte 16, Zeile 14 * --- | 1,9 | |
| A | FR-A-2 419 610 (COMPAGNIE INDUSTRIELLE DES TELECOMMUNICATIONS CIT-ALCATEL) * Figur 1; Seite 5, Zeilen 23-27 * ----- | 2 | |

**RECHERCHIERTE SACHGEBIETE (Int. Cl.4)**

H 03 F

Der vorliegende Recherchenbericht wurde für alle Patentansprüche erstellt

| Recherchenort | Abschlußdatum der Recherche | Prüfer |
|---|---|---|
| DEN HAAG | 31-05-1989 | TYBERGHIEN G.M.P. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes Dokument